# EUROPÄISCHE PATENTSCHRIFT

(11) **EP 1 620 351 B1**
(45) Veröffentlichungstag und Bekanntmachung des Hinweises auf die Patenterteilung: **04.06.2008**
(21) Anmeldenummer: 04731347.3
(22) Anmeldetag: 06.05.2004
(51) Int. Cl.: B81B 3/00, H01L 35/02, H01L 35/32, G01J 5/12

(54) **STRAHLUNGSSENSOR, WAFER, SENSORMODUL UND VERFAHREN ZUR HERSTELLUNG EINES STRAHLUNGSSENSORS**
RADIATION SENSOR, WAFER, SENSOR MODULE, AND METHOD FOR THE PRODUCTION OF A RADIATION SENSOR
CAPTEUR DE RAYONNEMENT, TRANCHE, MODULE CAPTEUR ET PROCEDE DE FABRICATION DUDIT CAPTEUR DE RAYONNEMENT

(30) Priorität: 07.05.2003 DE 10320357
(43) Veröffentlichungstag der Anmeldung: 01.02.2006
(73) Patentinhaber: Perkinelmer Optoelectronics GmbH & Co. Kg, 65199 Wiesbaden (DE)
(72) Erfinder: HAUSNER, Martin, 65193 Wiesbaden (DE); SCHILZ, Jürgen, 65527 Niedernhausen (DE); PLOTZ, Fred, 65232 Taunusstein (DE); KARAGÖZOGLU, Hermann, 65205 Wiesbaden (DE)
(74) Vertreter: Erny, Tobias
(86) Internationale Anmeldenummer: PCT/EP2004/004841
(87) Internationale Veröffentlichungsnummer: WO 2004/099063

(56) Entgegenhaltungen:
- EP-A- 0 599 364
- WO-A-01/00523
- DE-A- 10 046 621
- DE-A- 10 144 343
- DE-C1- 4 241 045
- LENEKE W ET AL: "THERMOPILE-ZEILEN-UND MATRIXSENSOR-ARRAYS FUER DIE POSITIONS-, ANWESENHEITS-UND BEWEGUNGSERKENNUNG" TECHNISCHES MESSEN TM, R.OLDENBOURG VERLAG. MUNCHEN, DE, Bd. 66, Nr. 3, März 1999 (1999-03), Seiten 104-108, XP000890600 ISSN: 0171-8096

## Beschreibung

Die Erfindung betrifft einen Strahlungssensor, einen Wafer, ein Sensormodul und ein Verfahren zur Herstellung eines Strahlungssensors nach den Oberbegriffen der unabhängigen Patentansprüche.

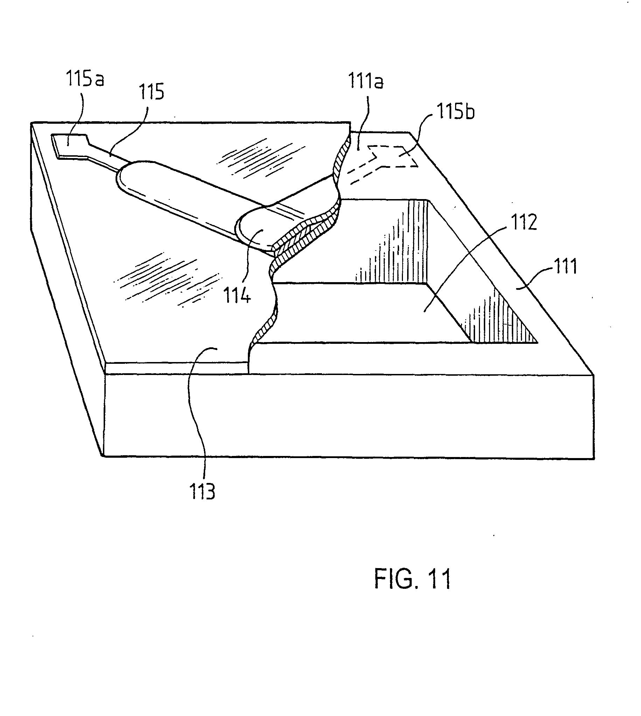

Eine Klasse von Strahlungssensoren kann so aufgebaut sein, daß einfallende Strahlung, beispielsweise Infrarotstrahlung (λ > 700 nm), dahingehend Veränderungen bewirkt, daß sie ein Sensorelement erwärmt, das nach Maßgabe der Temperatur bzw. der Temperaturänderung ein elektrisches Signal erzeugt. Da häufig die Temperaturänderung vergleichsweise gering sein wird, ist eine gute thermische Isolierung des eigentlichen Sensorelements nötig, um das Diffundieren der vergleichsweise geringen eingestrahlten Wärmemenge hin zu nicht wärmesensitiven Bereichen ("thermischer Kurzschluß") auf ein Minimum zu beschränken. Bekannt ist hierbei, auf einem Rahmen eine dünne Membran aufzuspannen und das Sensorelement auf dieser dünnen Membran auszubilden, so daß das eigentliche Sensorelement nicht unmittelbar in Kontakt mit massiven Wärmesenken steht. Eine typische Ausführungsform hierzu ist in Fig. 11 gezeigt: Ein Rahmen 111 beispielsweise aus Silicium umgibt ein rechteckiges Gesenk 112, das durchaus auch ein Durchloch sein kann. Über dem Gesenk 112 aufgespannt und am Rahmen 111.befestigt ist eine Membran 113, auf der ein Sensorelement 104 so angebracht ist, daß der elektrisch wirksame Bereich auf der Membran liegt und nicht über einer massiven Wärmesenke. Kontakte 105 greifen unter die Pole des Sensorelements 114 und können zum elektrischen Ableiten des sich ergebenden elektrischen Signals verwendet werden. Die Bond-Flächen 115a, b der Kontakte liegen über dem Rahmen, typischerweise über einem verbreiterten Balken 101 a des Rahmens, damit beim Bond-Vorgang die Membran 113 nicht zerstört wird. Typische Abmessungen dieser Sensorelemente sind Kantenlängen von einigen Millimetern, Gesenkdurchmesser, die 50 bis 90 % der Kantenlängen des Sensorelements betragen können, und Membrandicken von einigen Mikrometern. Nachteil dieses Aufbaus ist es, daß wegen der Ecken des Gesenks 112 die Aufhängung der Membran eben an den Ecken unstetig ist, so daß es zu Verwerfungen und Faltungen kommen kann. Darüber hinaus müssen für die Bond-Flächen der Kontakte 115 vergleichsweise breite Stege vorgesehen sein, so daß der Aufbau insgesamt vergleichsweise "groß" wird.

Es sind weiterhin Drucksensoren bekannt, bei denen in einem Substrat ein mehr oder minder rundes Loch ausgebildet ist. Das Loch wird vollständig von einer Membran überspannt, die sich entsprechend einem Differenzdruck zwischen Vorder- und Rückseite verschiebt, was beispielsweise kapazitiv oder galvanisch oder piezoresistiv ausgewertet werden kann. Die geometrischen Abmessungen solcher Sensoren sind meist wesentlich größer als diejenigen von Strahlungssensoren, so daß weniger strenge Anforderungen an die Fertigungspräzision bei der Herstellung des Lochs gestellt werden müssen. Und bei kleinen Drucksensoren sind die das Loch überspannenden Membranen dicker und widerstandsfähiger (da sie ja eine mechanische Kraft aufnehmen müssen) ausgebildet als in Strahlungssensoren, so daß auch insoweit beim Herstellen des Lochs anders und insbesondere grobschlächtiger gearbeitet werden kann.

Selektiver Materialabtrag aus einer Substratoberfläche kann allgemein dadurch erfolgen, daß diejenigen Oberflächenbereiche, aus denen nichts abgetragen werden soll, maskiert werden und die verbleibenden, freien Bereiche einem Ätzmittel ausgesetzt werden. Ausgehend von den nicht maskierten Bereichen kann dann in die Tiefe des Substrats Material abgetragen werden. Dabei können jedoch verschiedene Probleme auftreten:
- Das Ätzmittel ätzt nicht nur die freien Oberflächenbereiche, sondern auch das Maskierungsmaterial. Je nach Einwirkungsdauer kann es zur Verdünnung oder zum vollständigen Abtrag der Maskierung und darauf folgend zum Abtrag aus der eigentlich zu schützenden Substratoberfläche kommen.
- Es kann zu Unterätzungen kommen. D.h., daß von den Seitenwänden des schon hergestellten Gesenks seitlich unter die Maske geätzt wird, so daß die Ränder unter der Maskierungsschicht ausgefranst und nicht definiert erscheinen. Außerdem sind die Wände des entstehenden Gesenks nicht glatt.
- Ungleichförmige Ätzraten innerhalb eines einzigen Gesenks und/oder über mehrere Gesenke auf einem Substrat hinweg führen zu undefinierten Tiefen.
- Unerwünschte Redepositionen weggeätzten Materials. Es kann sich weggeätztes Substrat- und/oder Maskierungsmaterial in unerwünschter Weise bzw. an ungünstigen Stellen auf dem Substrat und/oder der Ätzvorrichtung ablagern und zu unbrauchbaren Ergebnissen oder zu nicht mehr arbeitenden Ätzvorrichtungen führen.
- Bei der Herstellung tiefer Gesenke (Tiefe T > 200 µm) kann die Ätzgeschwindigkeit zu niedrig sein, um wirtschaftlich brauchbare Ergebnisse zu liefern.

Ätzprozesse können isotrop (d.h. in alle Richtungen gleichwirkend) oder anisotrop (in bestimmte Raumrichtungen besser als in andere Raumrichtungen wirkend) sein. Naßätzen ist ein in der Regel isotroper Ätzvorgang, der jedoch vergleichsweise langsam ist und zum Ätzen tiefer Gesenke beispielsweise in einem Siliciumwafer nicht geeignet ist. Anisotropes Nassätzen wird industriell für das Ätzen von Gesenken verwendet, allerdings mit dem Nachteil eines schrägen Winkels, was Platzverlust bzw. geometrische Nachteile mit sich bringt. Auch dieser Prozess ist relativ langsam, aber es können mehrere Wafer gleichzeitig prozessiert werden.

Trockenätzen hat einen höhere Ätzrate (Abtrag pro Zeit). Hierbei wird eine Ätzplasma (beispielsweise SF₆)erzeugt und zur Einwirkung auf die zu ätzenden Stellen gebracht. Unter "Plasma" sind hierbei auch hochionisierte (nicht vollständig ionisierte) Aggregatszustände zu verstehen. Es wird auch als RIE (Reaktives Ionenätzen, "Reactive Ion Etching") bezeichnet. Soweit tiefe Gesenke herzustellen sind, wird dies als DRIE ("Deep Reactive Ion Etching") bezeichnet, soweit Trockenätzen verwendet wird. Hier stellen sich die besonderen Anforderungen an die Homogenität des Ätzvorganges und die Widerstandsfähigkeit des Maskierungsmaterials. Eine weitere Erhöhung der Ätzgeschwindigkeit kann mit dem ICP-Ätzen erreicht werden. Hier wird hochionisierte Plasma durch induktive Energieeinkopplung erzeugt (ICP = Inductively Coupled Plasma). Die Ätzraten sind hierbei so hoch, daß mit üblichen Maskierungsschichten aus Polymeren oder Oxiden nur geringe Gesenktiefen erreicht werden können, bevor neben dem Substrat auch die Maskierungsschicht weggeätzt ist.

Andererseits ist es bekannt, Maskierungsschichten mit oder ganz (>98 Gew-%) aus metallischen Materialien, insbesondere Aluminium, zu verwenden. Sie haben die Eigenschaft, daß sie auch bei dünnen Maskierungsschichten auch beim ICP-Ätzen so widerstandsfähig sind, daß tiefe Gesenke hergestellt werden können, ohne daß die Maskierungsschicht vorher abgetragen wäre. Gleichwohl aber wird auch Material aus der Maskierungsschicht weggeätzt. Es lagert sich unter anderem in der Ätzvorrichtung wieder ab und dort auch an bzw. in den die induktive Einkopplung tragenden Röhren. Diese werden dadurch metallisch leitend, so daß sich die induktive Einkopplung und damit die Ätzrate anfänglich verschlechtert und schließlich zusammenbricht. Eine teure und aufwendige Reinigung des Gerätes ist die Folge.

Das Unterätzen der Maskierungsschicht wird durch ein Verfahren vermieden, wie es aus US 5 501 893 bekannt ist. Kurz gesagt werden hierbei abwechselnd (mit Periodizität weniger Sekunden) Ätzgas und ein Passivierungsgas der zu ätzenden Oberfläche zugeführt. Bei geeignetem Layout lagert sich das Passivierungsmittel im Passivierungsgas an den Seitenwänden des Gesenks ab, so daß das Ätzgas nur am Boden des Gesenks ätzt, so daß das Unterätzen vermieden und in etwa senkrechte Wände erzeugt werden.

EP 0 599 364 A2 beschreibt eine Infrarot-Erfassungsvorrichtung. Für ein nassgeätztes Sensorsubstrat schlägt sie vor, eine Vertiefung unter der Membran mit verrundeten Ecken oder runder Kontur auszubilden.

Die DE 101 44 343 A1 beschreibt einen Sensor zum berührungslosen Messen einer Temperatur. Der Sensor ist auf einer Membran über eine Aussparung angebracht, die durch Trockenätzen hergestellt wird.

Aufgabe der Erfindung ist es, einen Strahlungssensor, einen Wafer, ein Sensor-Array, ein Sensormodul und ein Verfahren zur Herstellung eines Strahlungssensors anzugeben, die zu einem vergleichsweise kleinen und mechanisch stabilen Strahlungssensor führen.

Diese Aufgabe wird mit den Merkmalen der unabhängigen Ansprüche gelöst. Abhängige Patentansprüche sind auf bevorzugte Ausführungsformen der Erfindung gerichtet.

Ein Strahlungssensor weist einen Träger auf, in dessen einer Oberfläche ein Gesenk in Form einer Vertiefung oder eines Durchlochs ausgebildet ist. Über dem Gesenk ist eine Membran ausgebildet, die das Gesenk ganz oder teilweise überspannt und am Träger angebracht ist. Auf der Membran ist das eigentliche Sensorelement vorgesehen. Das Gesenk hat in der Oberfläche des Trägers eine runde oder ovale Kontur

Während das Gesenk im Träger des Strahlungssensors runde oder ovale Konturen aufweist, ist die Außenkontur des Trägers vorzugsweise rechteckig oder quadratisch. Denkbar sind allerdings auch beispielsweise rauten-, dreiecks- oder sechseckförmige Außenkonturen und ovale Löcher oder ähnliches. In Eckbereichen des Strahlungssensors können elektrische Kontakte vorgesehen sein, insbesondere deren Bond-Flächen (Bond-Pads). Die Bond-Pads können sich insbesondere an diagonal gegenüberliegenden Ecken des Strahlungssensors befinden, und sie liegen zumindest bereichsweise oder vollständig nicht über dem Gesenk, sondern über dem massiven Träger, insbesondere in dem Winkel zwischen runder Kontur des Gesenks und dem Eck der Außenkontur des Trägers. Das Gesenk kann durch Ätzen von der Rückseite her hergestellt werden, insbesondere durch reaktives Ionenätzen (RIE) bzw. durch DRIE (deep reactive ion etching). Es kann auch ICP-Ätzen verwendet werden (ICP = "inductively coupled plasma"). Hierbei ergeben sich hohe Ätzraten.

Das Sensorelement kann ein Thermopile sein, das insbesondere warme und kalte Kontakte aufweist, wobei die warmen Kontakte sich über dem Gesenk auf der Membran befinden.

Bei der Herstellung der Strahlungssensoren werden mehrere der Sensoren auf einem Wafer ausgebildet, und dieser Wafer wird dann nach dem Ätzen der Gesenke in einzelne Strahlungssensoren oder Sensor-Arrays mit mehreren Strahlungssensoren zertrennt, bspw. zersägt. Die Anordnung der Strahlungssensoren bzw. deren Rohling auf dem Wafer bzw. im Sensor-Array kann einem rechtwinkligen, vorzugsweise quadratischem Raster oder auch einem rautenförmigen Raster folgen.

Ein Sensormodul weist einen wie oben beschrieben ausgebildeten Strahlungssensor oder ein Sensor-Array wie oben beschrieben auf und außerdem ein Gehäuse, in dem sich der Strahlungssensor oder das Sensor-Array befindet, ein optisches Fenster im Gehäuse, und elektrische Anschlüsse.

Nachfolgend werden bezugnehmend auf die Zeichnung einzelne Ausführungsformen der Erfindung beschrieben, es zeigen:
- Fig. 1: eine perspektivische Ansicht eines Strahlungssensorelements,
- Fig. 2: einen Schnitt durch den Aufbau der Fig. 1,
- Fig. 3: schematisch die Ansicht eines Wafers von unten,
- Fig. 4: ein Sensor-Array schematisch von oben,
- Fig. 5: den Schnitt durch ein Sensormodul,
- Figs. 6 bis 9: Abbildungen zur Erläuterung des Ätzvorgangs,
- Fig. 10: eine weitere Ausführungsform, und
- Fig. 11: schematisch einen bekannten Strahlungssensor.

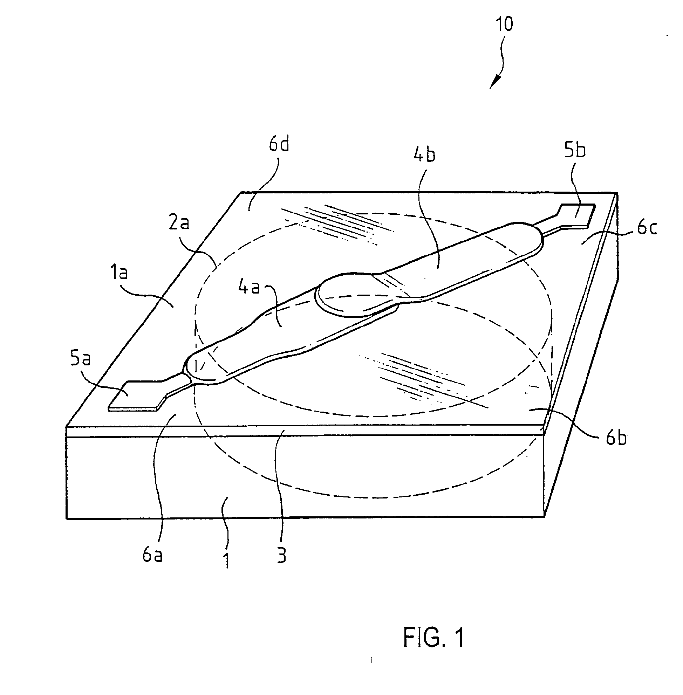

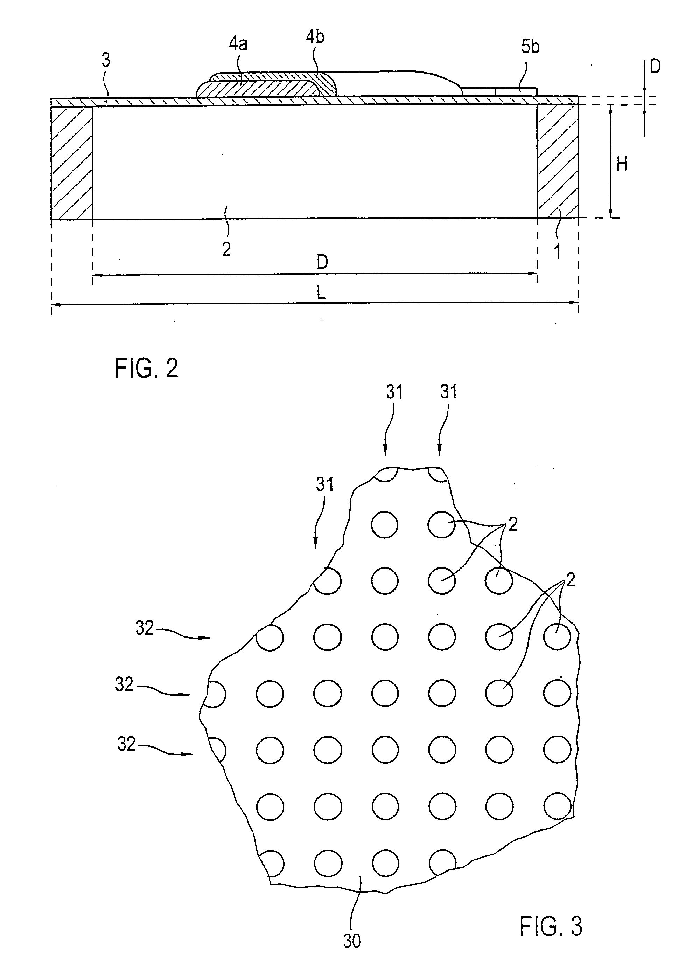

Fig. 1 zeigt einen erfindungsgemäßen Strahlungssensor in schematisch-perspektivischer Ansicht. Auf der Oberfläche eines Trägers 1 ist eine Membran 3 ausgebildet. Diese Membran überspannt das Gesenk 2 ganz oder teilweise, was in Fig. 2 im Schnitt deutlich zu sehen ist. Der Träger 1 hat dann, wenn das Gesenk 2 ein Durchloch ist, die Form eines Rahmens, und die Membran 3 überspannt den Rahmen an einer seiner Hauptflächen ganz oder teilweise. Es wird in diesem Zusammenhang darauf verwiesen, daß der Rahmen nicht allseitig geschlossen sein muß, er kann auch bereichsweise offen sein, beispielsweise an einer Seite.

Das Gesenk 2 hat in der Oberfläche des Trägers 1 eine ganz oder teilweise verrundete Kontur 2a. In Fig. 1 ist die Kontur 2a gestrichelt eingetragen, da sie in der perspektivischen Ansicht der Fig. 1 nicht sichtbar ist, da sie von der Membran 3 überdeckt ist. In Fig. 1 ist der Sonderfall einer vollständig verrundeten Kontur 2a des Gesenks 2 gezeigt. Die Kontur kann kreisförmig oder oval sein. Der Träger 1 selbst dagegen kann eine zumindest teilweise oder vollständig geradlinig begrenzte Außenkontur 1a haben, insbesondere rautenförmig, rechteckig oder quadratisch. Im Bereich 6a-d der Ecken des Trägers entstehen so vergleichsweise "massive" Bereiche in dem Sinn, daß hier der Träger 1 nicht eingesenkt ist. Über diesem Bereich können die Bond-Flächen bzw. allgemein elektrische Anschlüsse von Kontakten 5, 5a, 5b vorgesehen sein. Wenn sich die Bond-Flächen von elektrischen Kontakten 5a, 5b über dem massiven Teil des Rahmens 1 befinden, ist das anschließende Kontaktieren dieser Flächen mit Bond-Drähten mechanisch weniger kritisch.

Auf der Membran 3, insbesondere zumindest bereichsweise über dem Gesenk 2, befindet sich das eigentliche Sensorelement 4, 4a, 4b, das eine bestimmte Kennlinie zwischen Temperatur bzw. Temperaturänderung und einer elektrischen Größe, beispielsweise einer Spannung, hat. Es kann sich um ein Thermopile handeln. Der wärmesensitive Bereich des Sensorelements befindet sich ganz oder teilweise auf der Membran und über dem Gesenk 2. Dadurch ist der wärmesensitive Bereich thermisch gegen Wärmesenken isoliert. Insbesondere der Träger 1 selbst würde als Wärmesenke wirken und so die Signalstärke massiv verringern, wenn keine thermische Isolierung gegeben wäre.

Das Gesenk 2 kann ein Durchloch sein, das den Träger 1 vollständig durchdringt, oder es kann sich um lediglich eine wannenartige Vertiefung handeln, die ebenfalls wieder in der Oberfläche eine ganz oder bereichsweise verrundete Kontur hat und die von der Membran 3 ganz oder teilweise überdeckt wird.

Die Figuren 1 und 2 zeigen, daß das Sensorelement 4 selbst aus mehreren Komponenten 4a, 4b bestehen kann. Die elektrischen Kontakte 5 können geeignet gestaltete und angebrachte Metallisierungen sein, beispielsweise Aluminium- oder Kupferbeläge, die einerseits Bereiche aufweisen, die von außen zugänglich sind, beispielsweise Bond-Flächen, und andererseits Kontaktierungen hin zum eigentlichen Sensorelement 4, 4a, 4b.

Das Trägermaterial weist Silicium und/oder Galliumarsenid und/oder andere potenziell halbleitende Materialien auf. Das Membranmaterial weist eine oder mehrere dielektrische Schichten auf, z.B. Siliziumoxid und/oder Siliziumnitrid oder besteht vollständig aus einem oder beiden dieser Materialien.

Die Abmessungen des Strahlungssensors können einer oder mehreren der folgenden Angaben genügen: Höhe H des Trägers (im Querschnitt) > 50 µm, vorzugsweise > 200 µm, < 1500 µm, vorzugsweise < 600 µm. Kantenlänge L einer oder beider Kanten des Trägers 1 < 3 mm, vorzugsweise < 1,5 mm, weiter vorzugsweise < 1 mm, Durchmesser D des Gesenks > 55 %, vorzugsweise > 65%, < 90%, vorzugsweise < 80% der Trägerkantenlänge L, Dicke der Membran < 3µm, vorzugsweise < 2µm, weiter vorzugsweise < 1µm.

Fig. 3 zeigt einen Ausschnitt aus einem Wafer 30 während der Herstellung der beschriebenen Strahlungssensoren 10. Der Wafer ist von "unten" in dem Sinne gezeigt, daß die Seite zu sehen ist, die später bei den Strahlungssensoren 10 die Unterseite wird, also das, was auch in den Figuren 1 und 2 die Unterseite ist. In Fig. 3 erkennt man, daß viele Gesenke 2 matrixartig ausgebildet sind bzw. während des Ätzvorgangs ausgebildet werden. Jedes einzelne Gesenk 2 entspricht einem einzelnen zukünftigen Strahlungssensor 2. Schon vor dem Ätzen kann auf der anderen Seite des Wafers die später die Membran 3 bildende Schicht ausgebildet sein und ggf. zwischen der Waferoberfläche und der Membranschicht noch eine Ätzstoppschicht, die den Ätzvorgang stoppt, wenn von der anderen Seite her das Ätzmittel "von unten" bis zur Membranschicht bzw. Ätzstoppschicht durchdringt.

Man erkennt, daß die vorzugsweise ovalen bzw. runden und insbesondere kreisrunden Gesenke 2 in einem vorzugsweise rechtwinkligen oder quadratischen Raster angeordnet sind. Die Determinierung der Ätzstellen entsprechend den einzelnen Gesenken 2 erfolgt durch eine geeignete Maskierung, was weiter hinten beschrieben wird. Die matrixartige Anordnung der den einzelnen Strahlungssensoren 10 entsprechenden Gesenke 2 erfolgt längs Spalten 31 und Reihen 32 auf dem Wafer 30.

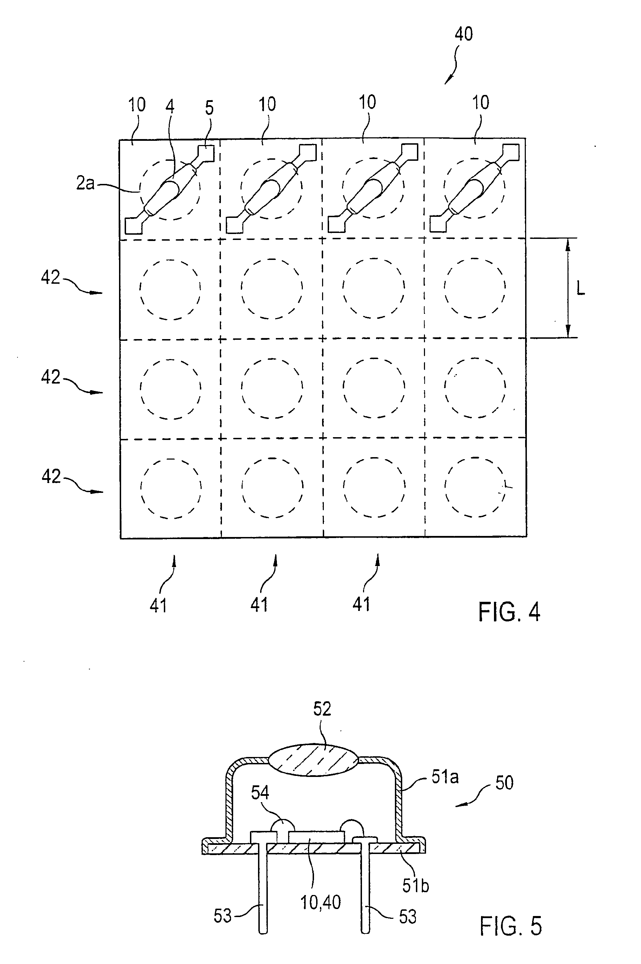

Fig. 4 zeigt schematisch - nun wieder von oben - ein Sensor-Array 40. Das Array 40 weist mehrere Strahlungssensoren 10 auf, im gezeigten Beispiel 4x4, die längs vier Spalten 41 und viel Zeilen 42 angeordnet sind. Sie weisen jeweils die eigentlichen Sensorelement 4 und geeignet angebrachte Kontaktflächen 5 auf. Sie sind jeweils individuell wie oben beschrieben ausgebildet. Sie müssen nicht, können aber zueinander gleichartig ausgebildet sein. Mit solchen Sensor-Arrays wird zusammen mit einer abbildenden Optik eine Ortsauflösung zu einer von den Strahlungssensoren zu erfassenden Strahlungsquelle möglich. Das Sensor-Array 40 kann als Ganzes aus einem Wafer 30, wie er in der Fig. 3 gezeigt ist, herausgeschnitten werden. Anders als in der Fig. 4 gezeigt, können die elektrischen Kontakte 5 der einzelnen Sensorelemente 4 der Strahlungssensoren 10 des Arrays 40 in den randnahen Bereichen des Arrays 40 angeordnet sein. Die Kontaktflächen können insbesondere für alle Strahlungssensoren im Bereich der außenliegenden Sensorelement 10 vorgesehen sein.

Fig. 5 zeigt ein Sensormodul 50. Im Sensormodul ist ein Strahlungssensor 10 oder ein Sensor-Array 40 vorgesehen. Daneben können weitere Schaltungskomponenten im Modul 50 vorhanden sein, etwa Multiplex-Einrichtungen oder Analog/Digital-Wandlungseinrichtungen und digitale Speicher und Prozessoren zur Signalaufbereitung und - weiterleitung. Das Modul weist außerdem elektrische Anschlüsse 53 auf, die aus dem Gehäuse herausragen und mehr oder minder direkt mit den Sensorelementen bzw. Strahlungssensoren bzw. dem Sensor-Array oder einer zugehörigen Elektronik verbunden sind, beispielsweise über Bond-Verbindungen 54.

Das Modul weist ein Gehäuse 51a, 51b auf, beispielsweise bestehend aus einer Bodenplatte 51b und einem darübergestülpten Becher 51a. Das Gehäuse kann ein Normgehäuse sein, beispielsweise TO5 oder ähnliches. Außerdem ist im Gehäuse ein Strahlungsfenster 52 vorgesehen, das den Einfall der zu sensierenden Strahlung erlaubt. Es kann weiterhin ein optisches Abbildungselement vorgesehen sein, mit dem die einfallende Strahlung auf die Oberfläche des Strahlungssensors bzw. des Arrays fokussiert wird. Beispielsweise kann eine Linse 52 vorgesehen sein, die in einem die Strahlungsdurchlässigkeit und die Fokussierung/Abbildung bewirkt. Es kann aber auch beispielsweise ein Spiegel mit der Brennebene in der Sensorarrayebene vorgesehen sein.

Ein Verfahren zur Herstellung eines Strahlungssensors 10 kann folgende Schritte aufweisen:

Herstellen eines ebenen Wafers. Der Wafer besteht aus dem Material, aus dem der Träger des Strahlungssensors bestehen soll. Der Wafer kann so groß sein, daß mehrere Strahlungssensoren gleichzeitig matrixartig angeordnet hergestellt werden können. Der Wafer kann die Dicke haben, die später die Höhe H eines Strahlungssensors sein soll. Auf der späteren Oberseite (in Figuren 1 und 2 oben) des Wafers wird dann eine Ätzstoppschicht aufgebracht und darüber eines mechanisch stabile Schicht, die später die Membran 3 bildet.

Auf der anderen Oberfläche des Wafers wird dann eine Ätzmaske mit Öffnungen aufgebracht, deren Kontur der gewünschten Kontur 2a des Gesenks 2 im Träger 1 entspricht. Somit hat auch die Ätzmaske Öffnungen mit ganz oder bereichsweise verrundeter Kontur.

Danach wird von der mit der Ätzmaske überzogenen Seite des Wafers her der Wafer geätzt, vorzugsweise trocken, bis der Wafer durchgeätzt ist, also die Ätzstoppschicht auf der anderen Oberfläche des Wafers erreicht wird.

Zu geeigneten Zeitpunkten im Herstellungsprozeß erfolgt das Aufbringen der Metallisierungen für die elektrischen Kontakte 5, das Aufbringen der eigentlichen Sensorelemente 4 und das Zersägen des Wafers in einzelne Strahlungssensoren oder in Sensor-Arrays mit mehreren Strahlungssensoren.

Nachfolgend werden ein Abtragverfahren sowie ein Maskierungsmaterial für ein Substrat, etwa einen wie eben genannten Wafer, und ein Substrat bzw. ein Wafer mit einem solchen Maskierungsmaterial beschrieben. Die hier beschriebene Technologie kann zur Bildung der beschriebenen Strahlungssensoren verwendet werden.

Sie betrifft insbesondere Tiefenstrukturierung in Silicium oder Germanium oder allgemein in einem Halbleiter oder einem als Halbleitersubstrat geeignetem Material.

Zur Herstellung eines Gesenks, beispielsweise in einem Träger für einen Strahlungssensor 10 wie vorher beschrieben, wird hierbei ein Trockenätzverfahren verwendet. Es eignet sich auch insbesondere zur Herstellung von Gesenken mit ganz oder teilweise verrundeten Konturen, da die Ätzrichtung nicht durch Kristallorientierungen beeinflußt wird. Die Maskierung des Wafers vor dem Abtrag erfolgt ganz oder teilweise auch mit einem metallischen Material, vorzugsweise Aluminium oder bestimmte Legierungen. Schließlich werden Maßnahmen ergriffen, um die Redeposition des auch weggeätzten Maskenmaterials (Metalls), insbesondere am Ätzgerät, zu verhindern. Vorzugsweise wird beim Ätzen induktive Energie in das Ätzmedium eingekoppelt (ICP). Hier kann die Verhinderung der Redeposition an sensitiven Gerätekomponenten dadurch erreicht werden, daß das Substrat ausreichend weit von der induktiven Einkopplung entfernt gehalten wird. Der Abstand kann mindestens 8, vorzugsweise mindestens 10, weiter vorzugsweise mindestens 13 cm sein. Der Abstand kann auch mindestens die doppelte, vorzugsweise mindestens die dreifache mittlere, freie Weglänge der Plasmaatome sein. Die Tiefe des herzustellenden Gesenks beträgt vorzugsweise mindestens 80 µm, weiter vorzugsweise mindestens 150 µm, weiter vorzugsweise mindestens 300 µm. Es kann auch vollständig durch einen Wafer hindurchgeätzt werden (bzw, bis zu einer Ätzstoppschicht auf der anderen Seite des Wafers).

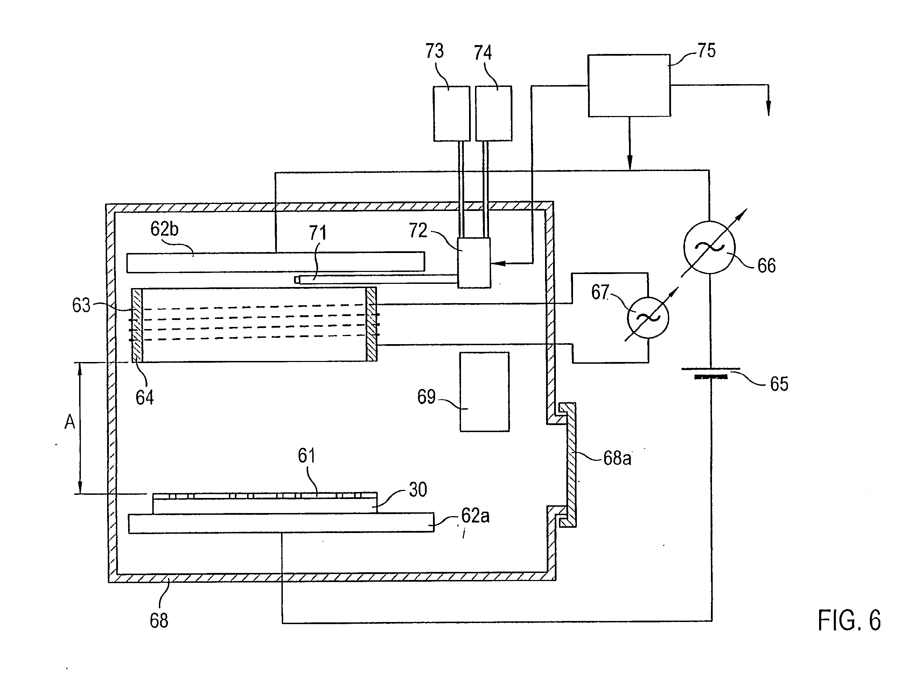

Fig. 6 zeigt Verhältnisse während des Ätzvorganges. Mit 68 ist ein Vakuumbehälter bezeichnet, der während des Ätzvorganges evakuiert wird. Der Druck während des Ätzens beträgt vorzugsweise unter 5 Pa, weiter vorzugsweise unter 3 Pa. Eine Öffnung 68a ist vorgesehen, um einen Wafer 30 mit Maskierung 61 darauf einführen bzw. wieder entnehmen zu können. Der Wafer 30 mit Maskierung 61 kommt auf einem Tisch zu liegen, der hier schematisch als Platte 62a eines Kondensators dargestellt ist, dessen gegenüberliegende Platte 62b oben in der Kammer 68 angebracht ist. An den Kondensator wird während des Ätzens eine Gleichspannung 65 von vorzugsweise 20 - 100 V sowie eine Wechselspannung 66 (Frequenz beispielsweise 13,56 MHz) angelegt. 71 bezeichnet einen Gaseinlaß, der zwischen die Platten 62a, 62b des Kondensators einerseits Ätzgas und andererseits gegebenenfalls auch Passivierungsgas einleitet. Hierzu ist eine Flußsteuerung 72 vorgesehen, die aus entsprechenden Vorratsbehältern 73 und 74 jeweils abwechselnd das eine bzw. das andere Gas dem Auslaß 71 zuführt.

Die induktive Energieeinkopplung erfolgt mittels einer Spule 63 mit wenigen Windungen (Windungszahl n < 6 vorzugsweise < 4). Diese Spule ist auf einem beispielsweise röhrenförmigen Träger 64, der aus einem dielektrischen Material wie beispielsweise Aluminiumoxid, Aluminiumnitrid, Quarz, Hartglas, Quarzglas oder Mischungen mit einem oder mehreren dieser Materialien bestehen kann, aufgebracht und wird mit einer Wechselspannung einer Frequenz von beispielsweise ebenfalls 13.56 MHz oder allgemein im Bereich von 4 MHz bis 41 MHz und einer Leistung von 0,5-5 KW versorgt. Die Ätzrate ist vorzugsweise größer 1 µm/min, vorzugsweise größer 2 µm/min.

Der Träger 64 kann sich unmittelbar an bzw. unter der Platte 62b des Kondensators befinden. Es können mehrere Dauermagnete vorgesehen sein, die so in Reihe angeordnet sein können, daß sich Nord- und Südpole abwechseln. Es können mehrere (nicht gezeigte) Dauermagnete vorzugsweise regelmäßig verteilt am Umfang und weiter vorzugsweise außerhalb des Trägers 64 angebracht sein. Pole des durch die Dauermagnete erzeugten Magnetfeldes können in axialer Richtung des Trägers 64 beabstandet sein. Die Dauermagnete können länglich sein und sich in Axialrichtung des Trägers 64 bzw. in Richtung des Gasflusses erstrecken. Die Magnete können hierbei über den Umfang verteilt abwechselnd gegenparallel angeordnet sein (N-S, dann S-N, dann wieder N-S, ...). Die Dauermagnete haben die Aufgabe, die Induktionswirkung für die Ionen und Elektronen gleichförmiger zu machen und den Absolutwert der Elektronentemperatur am Wafer zu verringern.

Mit 69 sind weitere Komponenten innerhalb des Vakuumbehälters 68 angedeutet, beispielsweise Handling-Automaten u.ä.. Eine Steuerung bzw. Regelung 75 steuert bzw. regelt die einzelnen Komponenten. Nicht gezeigt ist eine Pumpe zum Evakuieren des Behälters während des Betriebes.

Die Maskierung 61 des Wafers 30 weist ein metallisches Material oder eine Legierung auf, vorzugsweise mit Aluminium, oder besteht vollständig (> 98 Gew-%) daraus. Der Abstand A zwischen-zu ätzender Oberfläche und Unterkante des Spulenträgers 64 oder der Spule 63 selbst beträgt mindestens 8 cm, vorzugsweise mindestens 10 cm, weiter vorzugsweise mindestens 12 cm oder mindestens die zweifache mittlere freie Weglänge der Ätzatome, vorzugsweise mindestens die dreifache mittlere freie Weglänge. Dadurch ist sichergestellt, daß die Redeposition des auch weggeätzten Aluminiums an der Innenwand des Spulenträgers 64 verhindert wird. Dadurch wird dieser nicht leitend und blockt somit auch nicht das eingekoppelte Magnetfeld.

Die Maskierung kann alternativ zu oder zusammen mit Aluiminium auch Cr oder Ni oder Pt oder Au oder Fe als Hauptbestandteil (> 90 Gew.-%, vorzugsweise > 96 Gew.-%) aufweisen. Es können auch Aluminium- oder Nickellegierungen verwendet werden, z. B. AlCu, AlSi, AlTi, NiFe, NiCr, oder auch die Chromlegierung CrAu. Insbesondere folgende Legierungen sind als Maskierungsmaterial denkbar:
AlNiFe, z. B. 11-13 Al, 21-23 Ni, Rest Fe, "AlNi 090",
AlNiFe, z. B. 13-15 Al, 27-29 Ni, Rest Fe, "AlNi 120",
AlNiCo, z. B. 9-11 Al, 19-21 Ni, 14-16 Co, >1 CuTi, Rest vorzugsw. Fe, "AlNiCo 160",
AlNiCo, z. B. 11-13 Al, 18-20 Ni, 14-16 Co, 3-5 Cu, Rest vorzugsw. Fe, "AlNiCo 190",
AlCU, z. B. 0,5-2 Cu, Rest Al,
AlSi, z. B. 0,5-2 Si, Rest Al,
AlTi, z. B. max. 3, vorzugsw. max. 1,5 Ti, Rest Al,
NiFe, z. B. 35-37 Ni, Rest Fe, "Hyperm 36 M",
NiFe, z. B. 49-51 Ni, Rest Fe, "Hyperm 52",k
NiCr, z. B. 78-82 Ni, Rest Cr,
CrAu, z. B. 45-55 Cr, Rest Au.
Die obigen dimensionslosen Zahlen sind Gewicht- oder Volumen-Prozentangaben. Besonders bevorzugt sind die jeweiligen Mittelwerte der angegebenen Bereiche.

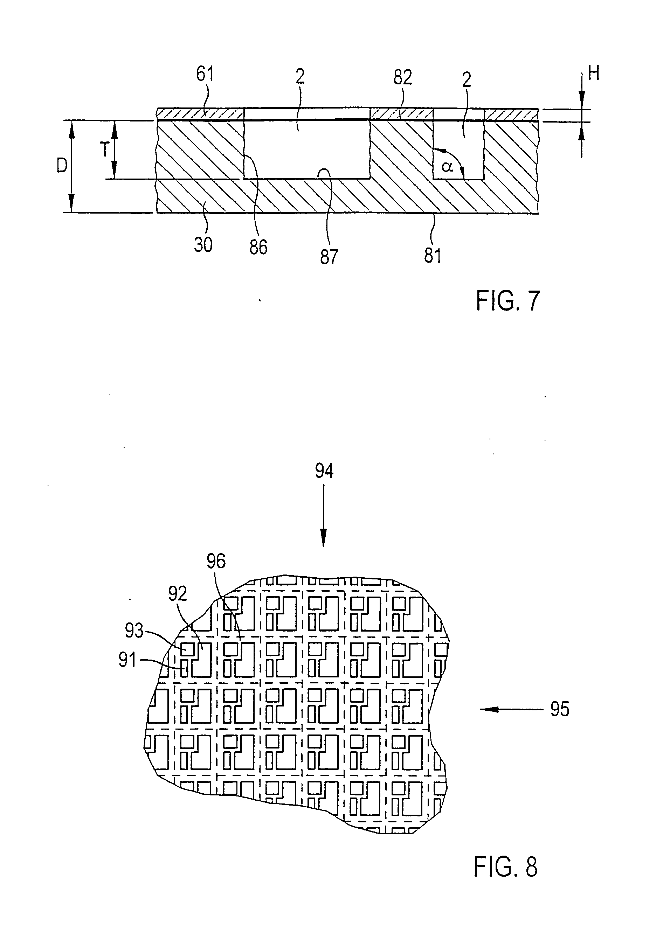

Figur 7 zeigt den Wafer 30 schematisch vergrößert im Schnitt. Auf dem Wafer 30 ist die Maskierung 61 angebracht. Die Maskierung 61 weist Metall oder eine Legierung oder ein Kompositmaterial mit Metall auf oder besteht vollständig daraus. Bevorzugtes Material ist Aluminium bzw. eine Aluminiumlegierung. Die Legierung kann mindestens 90 Gew.-% Metall bzw. Aluminium aufweisen. Mit 2 sind schon ausgebildete Gesenke bezeichnet, die bis zu einer gewissen Tiefe in den Wafer hineingeätzt sind. Die momentane Tiefe ist dabei mit T bezeichnet. Die Dicke D des Wafers kann einige hundert µm betragen und beispielsweise zwischen 150 µm und 600 µm liegen. Die Höhe H der Maskenschicht 61 beträgt weniger als 1 µm, vorzugsweise weniger als 500 nm. Die Wände können in etwa senkrecht hergestellt werden. Der Winkel α einer Wand bzw. aller Wände zum Boden kann im Bereich zwischen 85° und 95° liegen.

Beim ICP-Ätzen in die Tiefe des Wafers hinein kann abwechselnd Ätz-und Passivierungsgas zugeführt werden. Dies kann durch die Flußsteuerung 72 gegebenenfalls durch Maßgabe der übergeordneten Steuerung 75 erfolgen. Die Gase werden aus den Reservoirs 73 für Ätzgas und 74 für Passivierungsgas zugeführt. Die einzelnen Phasen können jeweils einige Sekunden dauern (insbesondere jeweils unter 10 s, vorzugsweise unter 6 s) und lösen einander unmittelbar ab. Die Evakuierung kann kontinuierlich erfolgen.

Fig. 8 zeigt schematisch die Draufsicht auf einen Ausschnitt eines Wafers. Gezeigt ist ein sich wiederholendes Muster von Vertiefungen, wobei die einzelnen Exemplare des Musters längs Zeilen 95 und Spalten 94 angeordnet sind. Die gestrichelten Linien dienen lediglich der Visualisierung und sind tatsächlich nicht vorhanden. Fig. 8 zeig eckige und damit nicht erfindungsgemäße Gesenkkonturen. Anstelle eckiger Konturen können aber auch runde oder ovale Konturen geätzt werden, wie dies in Fig. 3 gezeigt ist.

Pro einzelnem Muster sind unterschiedliche Vertiefungen 91, 92 und 93 vorgesehen. Diese entsprechen Auslassungen in der Maske 96, die die übrige Waferfläche vorzugsweise vollständig und vorzugsweise auch über die (vertikale) Umfangsseite des Wafers 30 bedeckt. Auf diese Weise können auf einem Wafer in einem Herstellungsschritt gleichzeitig viele gleichartige Vertiefungsmuster hergestellt werden, die nach dem Ausbilden der Vertiefungen voneinander getrennt werden.

Die zu ätzende Fläche kann mindestens 8 %, vorzugsweise mindestens 20 % der Substratoberfläche betragen, weiter vorzugsweise mehr als 35 %. Das Substrat selbst kann ein scheibenförmiger Wafer sein, der beispielsweise im wesentlichen kreisförmig ist und einen Durchmesser von mindestens 10 cm, vorzugsweise mindestens 15 cm hat. Der Wafer selbst kann Silicium aufweisen oder ganz daraus bestehen. Vorzugsweise ist er kristallines Silicium.

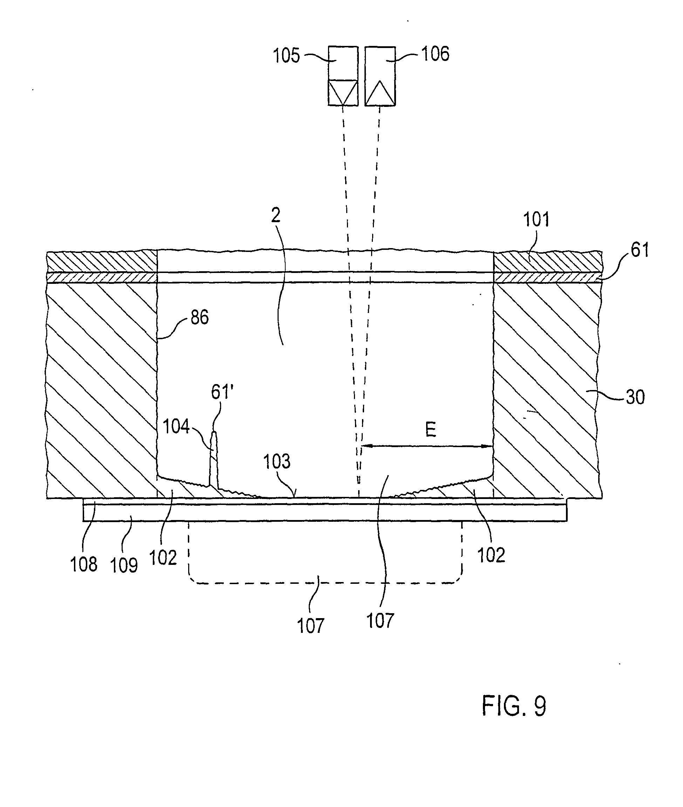

Fig. 9 zeigt Verhältnisse beim Durchätzen eines Substrats bzw. Wafers 30. Gezeigt ist der Zustand, in dem der Wafer schon fast.vollständig von oben bis unten durchgeätzt wurde. Auf der anderen Substratoberfläche (in Fig. 9 unten) wurde in dieser Ausführungsform schon vor dem Ätzvorgang im Bereich des Durchtritts des Loches eine Ätzstoppschicht 108 vorgesehen, auf der eine dünne Membran 109 aufgebracht ist, auf der später (oder auch gleich) eine thermisch isoliert zu haltende elektronische Komponente 107 ausgebildet werden kann.

Das wie oben beschriebene Ätzen hat zu dem Ergebnis geführt, daß eher in der Mitte des Gesenks 2 schon bis zur Ätzstoppschicht 108 durchgeätzt wurde, die eine vergleichsweise glatte Oberfläche 103 aufweist, während eher in den Ecken noch Bereiche 102 des Substratmaterials stehen geblieben sind, die eine vergleichsweise rauhe Oberfläche aufweisen. Gelegentlich kann durch Redeposition von Maskenpartikeln 61' die Bildung von Nadeln 104 auftreten.

Die Erkennung eines Zustands wie in Figur 9 gezeigt kann durch einen Tiefensensor 105, 106 erfolgen. Es kann sich beispielsweise um eine Lichtquelle, insbesondere eine Laserlichtquelle 105 handeln, die vorzugsweise in die Mitte (Entfernung E vom Rand > 20 %, vorzugsweise > 40 % der Querabmessung Q (Durchmesser oder Kantenlänge) des Gesenks 2 strahlt. Ein Sensor 106 wertet das reflektierte Licht aus. Die optischen Pfade sind schematisch gestrichelt angedeutet. Solange Laserlicht von der vergleichsweise rauhen Oberfläche des noch wegzuätzenden Substrats (wie schematisch bei 102 gezeigt) reflektiert wird, ist die Reflektion vergleichsweise ungerichtet und somit das am Sensor 106 empfangene, reflektierte Licht schwach. Wenn dagegen in der Regel beginnend in der Mitte des Gesenks 2 die Ätzstoppschicht 108 freigelegt wird, wird von der dann glatteren Oberfläche 103 zunehmend gerichtet reflektiert, so daß die beim Sensor 106 empfangene Intensität steigt.

Somit kann beispielsweise die Intensität des empfangenen, reflektierten Lichts auf einen Schwellenwert abgefragt werden. Es ist auch möglich, die erste Ableitung (die Veränderung des empfangenen Signals) auf einen Schwellenwert abzufragen. Die erste Ableitung kann zeitdiskret gebildet werden. Allgemein kann die Tiefenmessung durch Auswertung reflektierten Lichts erfolgen.

Wenn die Ätzstoppschicht 108 schon teilweise freigelegt ist, kann auf einen anderen Ätzvorgang umgeschaltet werden, vorzugsweise wird ein isotroper Ätzvorgang verwendet, um zum einen die Ätzstoppschicht 108 zu schonen und zum anderen in den Eckbereichen 102 sowie Nadeln 104 wegätzen zu können. Dies kann nach wie vor mittels ICP erfolgen. Es kann jedoch der Gasdruck erhöht und/oder die angelegte Vorspannung verringert werden. Durch Erhöhung des Drucks sinkt die freie Weglänge, und die Bewegungsrichtung der Ionen ist weniger streng an den Feldlinien des angelegten Gleichspannungsfelds ausgerichtet, so daß der Ätzvorgang isotroper wird. Auch durch Verringerung der angelegten Gleichspannung ergibt sich ein ähnlicher Prozeß bzw. ein isotroperer Ätzvorgang.

Nach diesem zweiten Ätzvorgang kann zuletzt noch auf einen dritten Ätzvorgang umgeschaltet werden, bei dem vorzugsweise die angelegte Vorspannung Null ist. Ansonsten kann abermals trocken und/oder mit induktiv energiegekoppeltem Plasma geätzt werden. Dieser dritte Ätzvorgang ist vorzugsweise isotrop.

Nach Beendigung des Ätzvorgangs wird die Maske 61 entfernt. Dies kann durch nasses Ätzen erfolgen. Davor kann eine Entfernung von auf der Maske abgelagerten Passivierungsmittelresten (Polymerresten) erfolgen. Dies kann beispielsweise mittels Sauerstoffplasma erfolgen. Die Entfernung der Maske selbst kann nasschemisch z.B. mit einer Phosphorsäure-Ätzmischung erfolgen. Alternativ oder anschließend kann eine Behandlung mit TMAH (Tetramethylammoniumhydroxid, vorzugsweise in wässriger Lösung - TMAHW) erfolgen.

Das Material, aus dem heraus Material abzutragen ist, ist vorzugsweise ein kreisförmig-kristalliner Wafer mit mindestens 10, vorzugsweise mindestens 15 cm Durchmesser.

Das Maskenmaterial weist vorzugsweise Aluminium als seine Hauptkomponente auf (Anteil > 90 Gew.-%, vorzugsweise > 95 Gew. %). Daneben können weitere Elemente einlegiert sein, beispielsweise Kupfer (Anteil zwischen 0,5 und 2 Gew.-%, vorzugsweise unter 1 Gew.-%) und/ oder Silicium (Anteil zwischen 0,5 und 2 Gew.-%) und/oder Titan (Anteil unter 3 Gew.-%, vorzugsweise unter 1,5 Gew.-%). Dieses Maskierungsmaterial wird als selbständiger Teil der Erfindung angesehen. Auch werden Wafer, die mit einem solchen Maskierungsmaterial ganz oder teilweise bedeckt sind, als selbständiger Teil der Erfindung angesehen.

Die Erfindung kann allgemein bei der Tiefenstrukturierung von Substraten in der Mikromechanik eingesetzt werden, etwa zur Herstellung von Beschleunigungssensoren mit verschieblicher Masse oder von IR-Sensoren, die thermisch isoliert zu halten sind.

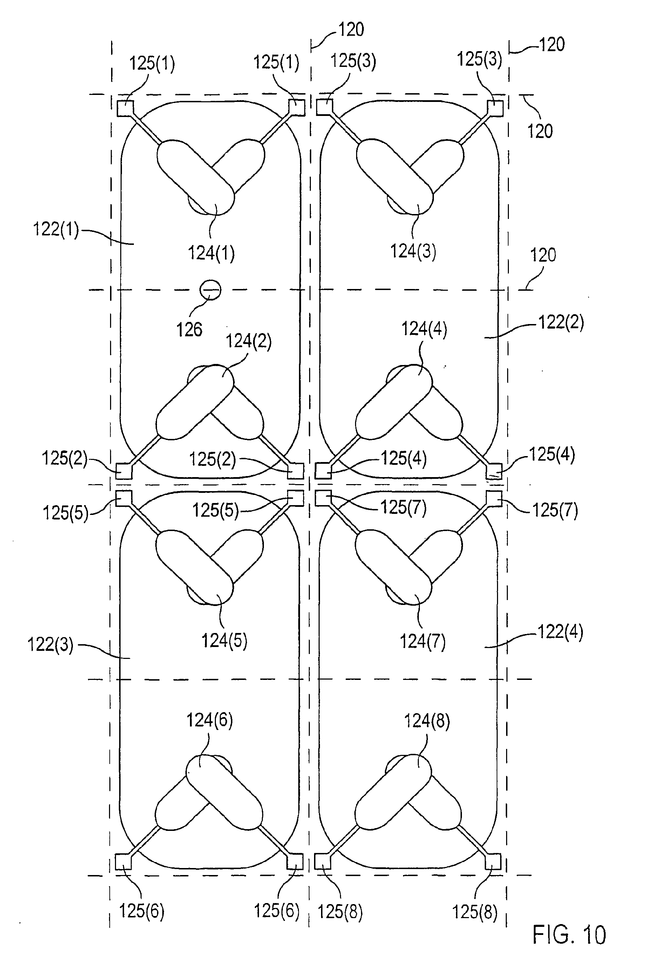

Fig. 10 zeigt schematisch eine weitere Ausführungsform. Während in den Ausführungsformen der Figuren 1, 3 und 4 jeweils immer ein Gesenk und eine Membran für jeweils ein Sensorelement vorgesehen sind, ist es auch, wie in Fig. 10 gezeigt, möglich, über einem Gesenk 122(1)-(4) mehrere Sensorelemente 124(1)-(8) vorzusehen, die elektrisch voneinander getrennt Signale abgeben können. Bei gleichbleibender Größe des Rasters für Sensorelemente wäre dann ein einzelnes Gesenk größer als die oben beschriebenen. Es sind dann jeweils auch eigene Kontakte 125(1)-(8) für jedes Sensorelement vorzusehen. Es können aber auch mehrere Sensorelemente zusammengeschaltet, insbesondere in Serie geschaltet werden, bspw. die über dem gleichen Gesenk angebrachten, bspw. zur Erhöhung der Signalstärke. 120 bezeichnet die virtuellen (real nicht vorhandenen) Linien des Gitternetzes, denen folgend die Sensorelemente ausgerichtet sind. Abermals können die Kontaktflächen der Kontakte in Rand- oder Eckbereichen vorgesehen sein.

Anders als einem rechtwinkligen Raster folgend können die Sensorelemente auch einem Dreiecks-Raster (60°) oder einem Sechseck-Raster (120°) folgend angeordnet sein, wobei auch hier jeweils mehrere Sensorelemente über einem Gesenk liegen können. Insbesondere in einem rechtwinkligen Raster können zwei (siehe Fig. 10) oder vier Sensorelemente über einem Gesenk vorgesehen sein. Insbesondere in einem Dreiecks-Raster (60°) können es zwei (ein Gesenk in einer Raute aus zwei Dreiecken), vier (ein Gesenk in einem großen Dreieck aus vier kleinen Dreiecken) oder sechs (ein Gesenk in einem Sechseck aus sechs kleinen Dreiecken) sein, und insbesondere in einem Sechseckraster können es sechs sein.

Wenn mehrere Sensorelemente über einem Gesenk angeordnet sind, bleiben diese vorzugsweise physisch verbunden und kommen dann vorzugsweise in einem Sensormodul mit mehreren Sensorelementen zum Einsatz.

Die Leiterbahnen zur Kontaktierung von Sensorelementen können so ausgeführt sein, dass sie im Bereich zwischen einzelnen Sensorelementen verlaufen, und sie können auch mächtiger (breiter, höher) ausgeführt sein, als dies nur unter elektrischen Gesichtspunkten notwendig wäre. Sie können dann auch als Wärmeisolation zwischen Sensorelementen dienen, indem sie zum einen eine thermische Kapazität bilden, die den Wärmeübertrag und damit Signalverfälschung zwischen einzelnen Sensorelementen verhindert, und zum anderen Wärme längs der Leiterbahn und somit von den Sensorelementen wegführen, was den gleichen Effekt hat.

Das Gesenk kann auch so ausgebildet sein, dass in einem Gesenk ein oder mehrere Stützpfosten ("Inseln") für die darüberliegende Membran stehen bleiben. Insbesondere bei großen Gesenken und dementsprechend Membranen für mehrere Sensorelemente kann dies sinnvoll sein. In Fig. 10 ist ein solcher Stützpfosten 126 angedeutet.

Ein Verfahren zum selektiven Abtragen von Material aus der Oberfläche eines Substrats zur Bildung einer Vertiefung weist die Schritte des Aufbringens einer Maske auf der Oberfläche des Substrats nach Maßgabe des gewünschten selektiven Abtrags und des Trockenätzens des Substrats auf, und ist dadurch gekennzeichnet, daß ein Metall, vorzugsweise Aluminium, zur Bildung der Maske verwendet wird. Beim Trockenätzen kann induktiv Energie in das Ätzmedium eingekoppelt werden. Das Substrat kann um mindestens die doppelte, vorzugsweise mindestens die dreifache, mittlere freie Weglänge der Plasmaatome von der induktiven Einkopplung entfernt gehalten sein. Das Substrat kann um mindestens 10 cm von der induktiven Einkopplung entfernt gehalten werden. Der Druck kann während des Ätzens unter 5 Pa, vorzugsweise unter 3 Pa, liegen. Abwechselnd können Ätzschritte und Passivierungsschritte für die Seitenwände der Vertiefung stattfinden. Bis zu einer Tiefe von mindestens 80 µm, vorzugsweise mindestens 300 µm, kann abgetragen werden. Der Materialabtrag kann bis zur anderen Seite des Substrats erfolgen. Eine Maske einer Dicke von unter 1,5 µm, vorzugsweise unter 0,6 µm, kann gebildet werden. Das Substrat kann bis zum Rand maskiert werden. Beim Aufbringen der Maske kann das Metall, vorzugsweise Aluminium, aufgedampft oder aufgesputtert werden. Beim Aufbringen der Maske kann eine metallische Schicht nach Maßgabe des gewünschten selektiven Abtrags geätzt werden. Das verwendete Metall kann mindestens 90 Gew-% Al aufweisen. Die Ätzposition (T) in Tiefenrichtung kann wiederholt bestimmt werden, wobei bei Erreichung einer bestimmten Position das Ätzen beendet oder auf einen zweiten Ätzprozeß umgeschaltet wird, der qualitativ anders oder mit anderen Betriebsparametern als der vorherige Ätzprozeß abläuft. Eine Tiefenbestimmung kann mittels Laserlicht erfolgen, dessen Eigenschaften nach der Reflektion vom Boden ausgewertet werden, insbesondere bezugnehmend auf die erste Ableitung eines erfaßten Signals. Im o.g. zweiten Ätzprozeß kann trocken mit induktiv energiegekoppeltem Plasma geätzt werden, wobei der Gasdruck höher und/oder die angelegte Vorspannung niedriger ist. Nach dem zweiten Ätzprozeß kann auf einen dritten Ätzprozeß umgeschaltet werden, der qualitativ anders oder mit anderen Betriebsparametern als der vorherige Ätzprozeß abläuft. Im dritten Ätzprozeß kann trocken isotrop und vorzugsweise mit induktiv energiegekoppeltem Plasma geätzt werden, wobei die angelegte Vorspannung 0 sein kann. Vor dem Entfernen der Maske kann vorzugsweise durch nasses Ätzen ein Veraschungsschritt für Polymerreste auf der Maske vorgesehen sein. Die Veraschung kann mittels Sauerstoffplasma erfolgen. Nach der Veraschung kann eine Behandlung mit Phosphorsäure-Ätzmischung und/oder Tetramethylammoniumhydroxid erfolgen. Das obige Verfahren kann eines oder mehrere der folgenden Merkmale aufweisen:
- das Substrat weist Si auf, vorzugsweise kristallines Silicium,
- der Materialabtrag erfolgt aus mehr als 8 %, vorzugsweise mehr als 20 % der Substratoberfläche,
- das Substrat ist ein scheibenförmiger Wafer mit mindestens 10 cm, vorzugsweise mindestens 15 cm Durchmesser.

Beschrieben wurde auch die Verwendung von Aluminium oder einer Aluminiumlegierung mit mindestens 90 Gew-% Al oder eines Kompositmaterials mit mindestens 90 Gew-% Al als Maskierungsmaterial für Substrate, die mit induktiv energiegekoppeltem Plasma trocken tiefzuätzen sind.

Ein Maskenmaterial zum Maskieren von zu ätzenden Wafern, das Aluminium aufweist, hat einen Anteil von Aluminium von mehr als 90 Gew.-%, vorzugsweise mehr als 95 Gew.-%, und beigemengtes Kupfer in einem Anteil zwischen 0,5 und 2 Gew.-%, vorzugsweise unter 1 Gew.-%, und/oder Silicium in einem Anteil zwischen 0,5 und 2 Gew.-% und/oder Titan in einem Anteil zwischen 0,2 Gew.-% und 3 Gew.-%, vorzugsweise unter 1,5 Gew.-%.

Ein Wafer mit einer Maskierungsschicht hat ein Maskenmaterial wie oben beschrieben.

## Patentansprüche

1. Strahlungssensor (10) mit
einem Träger (1),
einem in einer Oberfläche des Trägers (1) ausgebildeten Gesenk (2), das eine Vertiefung oder ein Durchloch sein kann, dessen Seitenwand senkrecht zur Trägeroberfläche verläuft und das durch Trockenätzen hergestellt wurde,
einem über dem Gesenk (2) auf einer das Gesenk (2) überspannenden Membran (3) ausgebildeten Sensorelement (4, 4a, 4b) , und
elektrischen Kontakten (5, 5a, 5b) für das Sensorelement (4, 4a, 4b) ,
**dadurch gekennzeichnet, daß**
das Gesenk (2) in der Oberfläche des Trägers (1) eine runde oder ovale Kontur (2a) hat.

2. Strahlungssensor (10) nach Anspruch 1, **dadurch gekennzeichnet, daß** der Träger (1) eine rechteckige und insbesondere quadratische Kontur (1a) hat.

3. Strahlungssensor (10) nach Anspruch 2, **dadurch gekennzeichnet, daß** ein oder mehrere elektrische Kontakte (5, 5a, 5b) in einem Eckbereich (6, 6a - 6d) des Sensors (10) vorgesehen sind.

4. Strahlungssensor (10) nach einem oder mehreren der vorherigen Ansprüche, **dadurch gekennzeichnet, daß** das Sensorelement (4, 4a, 4b) ein Thermopile ist.

5. Strahlungssensor nach einem oder mehreren der vorherigen Ansprüche, **dadurch gekennzeichnet, daß** über einem Gesenk mehrere Sensorelemente ausgebildet sind.

6. Strahlungssensor (10) nach einem oder mehreren der vorherigen Ansprüche, **gekennzeichnet durch** eines oder mehrere der folgenden Merkmale:
- das Membranmaterial weist ein Dielektrikum auf, insbesondere Siliziumoxid und/oder Siliziumnitrid,
- unter der Membran befindet sich eine Ätzstoppschicht, die ein Oxid aufweist, insbesondere Siliziumoxid,
- das Trägermaterial weist Silizium und/oder GaAs und/oder ein halbleitendes Material auf.

7. Strahlungssensor (10) nach einem oder mehreren der vorherigen Ansprüche, **gekennzeichnet durch** eine oder mehrere der folgenden Abmessungen:
- Trägerhöhe H größer 50 µm, vorzugsweise größer 200 µm, kleiner 1500 µm, vorzugsweise kleiner 600 µm,
- Trägerkantenlänge L kleiner 2 mm, vorzugsweise kleiner 1,5 mm,
- Gesenkdurchmesser D größer 55 %, vorzugsweise größer 65 %, und/oder kleiner 90 %, vorzugsweise kleiner 80 % der Trägerkantenlänge L,
- Membrandicke D kleiner 3 µm, vorzugsweise größer 0,1 µm.

8. Wafer (30) mit mehreren darauf ausgebildeten Rohlingen von Strahlungssensoren (10) nach einem oder mehreren der vorherigen Ansprüche, **dadurch gekennzeichnet, daß** die Rohlinge in einem rechtwinkligen, rauten-, dreiecks- oder sechseckförmigen Raster (31, 32) auf dem Wafer (30) ausgebildet sind.

9. Sensorarray (40) mit mehreren Strahlungssensoren (10) nach einem oder mehreren der Ansprüche 1 bis 7.

10. Sensorarray (40) nach Anspruch 9, **dadurch gekennzeichnet, daß** mehrere Strahlungssensoren (10) in zwei oder mehr Reihen (41) und in zwei oder mehr Spalten (42) angeordnet sind.

11. Sensormodul (50) mit
- einem Strahlungssensor (10) nach einem oder mehreren der Ansprüche 1 bis 7 oder einem Sensorarray (20) nach Anspruch 9 oder 10,
- einem Gehäuse (51), in dem sich der Strahlungssensor (10) oder das Sensorarray (20) befindet,
- einem optischen Fenster (52) im Gehäuse (51), und
- elektrischen Anschlüssen (53), die aus dem Gehäuse (51) ragen und die mit den Kontakten (5, 5a, 5b) verbunden sind.

12. Sensormodul (50) nach Anspruch 11, **gekennzeichnet durch** ein optisches Abbildungselement, insbesondere eine Linse (52) oder einen Spiegel.

13. Verfahren zur Herstellung eines Strahlungssensors (10), mit den Schritten:
Herstellen eines ebenen Wafers,
Aufbringen einer Ätzstoppschicht auf einer ersten Fläche des Wafers und darüber einer mechanisch stabilen Membran,
auf einer zweiten Fläche des Wafers Aufbringen einer Ätzmaske mit einer Öffnung, und
Trockenätzen von Gesenken des Wafers von der zweiten Fläche aus in Richtung auf die Ätzstoppschicht so, dass die Seitenwand des Gesenks (2) senkrecht zur ersten Fläche des Wafers verläuft,
**dadurch gekennzeichnet, daß**
eine Ätzmaske mit einer Öffnung mit runder oder ovaler Kontur aufgebracht und ein Gesenk mit dementsprechend rundem oder ovalem Querschnitt gebildet wird.

## Claims

1. Radiation sensor (10) comprising
a support (1),
a cavity (2) which may be a recess or a through hole formed in one surface of the support (1), the side wall of which extends vertically to the support surface and which has been formed by dry etching,
a sensor element (4, 4a, 4b) formed above the cavity (2) on a membrane (3) spanning the cavity (2), and
electric contacts (5, 5a, 5b) for the sensor element (4, 4a, 4b),
**characterised in that**
the cavity (2) in the surface of the support (1) has a round or oval contour (2a).

2. Radiation sensor (10) according to claim 1, **characterised in that** the support (1) has a rectangular and particularly a square contour (1a).

3. Radiation sensor (10) according to claims 2, **characterised in that** one or more electric contacts (5, 5a, 5b) are provided in a corner section (6, 6a - 6d) of the sensor (10).

4. Radiation sensor (10) according to one or more of the preceding claims, **characterised in that** the sensor element (4, 4a, 4b) is a thermopile.

5. Radiation sensor according to one or more of the preceding claims, **characterised in that** a plurality of sensor elements are formed above one cavity.

6. Radiation sensor (10) according to one or more of the preceding claims, **characterised by** one or more of the following features:
- the membrane material comprises a dielectric, particularly silicon oxide and/or silicon nitride,
- under the membrane an etching stop layer containing an oxide, particularly silicon oxide, is provided,
- the support material contains silicon and/or GaAs and/or a semiconductor material.

7. Radiation sensor (10) according to one or more of the preceding claims, **characterised by** one or more of the following dimensions:
- support height H: more than 50 µm, preferably more than 200 µm, less than 1,500 µm, preferably less than 600 µm,
- support edge length L: less than 2 mm, preferably less than 1. 5 mm,
- cavity diameter D: more than 55 %, preferably more than 65 % and/or less than 90 %, preferably less than 80 % of the support edge length L,
- membrane thickness D: less than 3 µm, preferably more than 0.1 µm.

8. Wafer (30) comprising a plurality of blanks of radiation sensors (10) according to one or more of the preceding claims, which are formed thereonon, **characterised in that** the blanks are arranged on the wafer (30) in a rectangular, rhombic, triangular or hexagonal grid (31, 32).

9. Sensor array (40) comprising a plurality of radiation sensors (10) according to one or more of claims 1 to 7.

10. Sensor array (40) according to claim 9, **characterised in that** a plurality of radiation sensors (10) are arranged in two or more rows (41) and in two or more columns (42).

11. Sensor module (50) comprising
- a radiation sensor (10) according to one or more of claims 1 to 7 or a sensor array (20) according to claim 9 or 10,
- a housing (51) in which the radiation sensor (10) or the sensor array (20) is located,
- an optical window (52) in the housing (51), and
- electric terminals (53) which protrude from the housing (51)and are connected to the contacts (5, 5a, 5b).

12. Sensor module (50) according to claim 11, **characterised by** an optical imaging element, particularly a lens (52) or a mirror.

13. Method for manufacturing a radiation sensor (10), comprising the steps of:
producing a plane wafer,
applying an etching stop layer on a first surface of the wafer and, thereon, a mechanically stable membrane,
applying an etching mask having one opening, and
dry etching of cavities of the wafer from the second surface in the direction towards the etching stop layer such that the side wall of the cavity (2) extends vertically to the first surface of the wafer,
**characterized in that**
an etching mask having an opening with round or oval contour is applied and a cavity with correspondingly round or oval cross-section is formed.

## Revendications

1. Capteur de rayonnement (10), constitué par :
un support (1),
une matrice (2) aménagé dans une surface du support (1), qui peut être un renfoncement ou une perforation, dont la paroi latérale est perpendiculaire à la surface du support et qui a été façonné par gravure à sec,
un élément capteur (4, 4a, 4b) formé au-dessus de la matrice (2) sur une membrane tendue au-dessus de la matrice (2), et
des contacts électriques (5, 5a, 5b) pour l'élément capteur (4, 4a, 4b),
**caractérisé en ce que**
la matrice (2) aménagée dans la surface du support (1) présente un contour (2a) rond ou ovale.

2. Capteur de rayonnement (10) selon la revendication 1, **caractérisé en ce que** le support (1) présente un contour (1a) rectangulaire et notamment carré.

3. Capteur de rayonnement (10) selon la revendication 2, **caractérisé en ce qu'**un ou plusieurs contacts électriques (5, 5a, 5b) sont prévus dans un angle (6, 6a - 6d) du capteur (10).

4. Capteur de rayonnement (10) selon une ou plusieurs des revendications précédentes, **caractérisé en ce que** l'élément capteur (4, 4a, 4b) est un thermocouple.

5. Capteur de rayonnement selon une ou plusieurs des revendications précédentes, **caractérisé en ce que** plusieurs éléments capteurs sont formés au-dessus d'une matrice.

6. Capteur de rayonnement (10) selon une ou plusieurs des revendications précédentes, **caractérisé par** une ou plusieurs des caractéristiques suivantes :
- la matière de la membrane est constituée d'un diélectrique, notamment un oxyde de silicium et/ ou un nitrure de silicium,
- on trouve sous la membrane une couche d'arrêt de gravure, qui comprend un oxyde, notamment de l'oxyde de silicium,
- le matériau du support comprend du silicium et/ou un arséniure de gallium et/ou un matériau semi-conducteur.

7. Capteur de rayonnement (10) selon une ou plusieurs des revendications précédentes, **caractérisé par** une ou plusieurs des dimensions suivantes :
- hauteur du support H supérieure à 50 µm, de préférence supérieure à 200 µm, inférieure à 1500 µm, de préférence inférieure à 600 µm,
- longueur de l'arête du support L inférieure à 2 mm, de préférence inférieure à 1,5 mm,
- diamètre de la matrice D supérieur à 55 %, de préférence supérieur à 65 %, et/ou inférieur à 90 %, de préférence inférieur à 80 % de la longueur de l'arête du support L,
- épaisseur de la membrane D inférieure à 3 µm, de préférence inférieure à 0,1 µm.

8. plaquette (30) constituée de plusieurs éléments permanents de capteurs de rayonnement (10) formés par-dessus selon une ou plusieurs des revendications précédentes, **caractérisé en ce que** les éléments permanents sont formés sur la plaquette (30) formant un quadrillage (31, 32) rectangulaire, en losange, triangulaire ou hexagonal.

9. Réseau de capteurs (40) comportant plusieurs capteurs de rayonnement (10) selon une ou plusieurs des revendications 1 à 7.

10. Réseau de capteurs (40) selon la revendication 9, **caractérisé en ce que** plusieurs capteurs de rayonnement (10) sont disposés sur deux rangées (41) ou plus et sur deux colonnes (42) ou plus.

11. Module capteur (50) comportant :
- un capteur de rayonnement (10) selon une ou plusieurs des revendications 1 à 7 ou un réseau de capteurs (20) selon la revendication 9 ou 10,
- un boîtier (51), dans lequel se trouve le capteur de rayonnement (10) ou le réseau de capteurs (20),
- une fenêtre optique (52) dans le boîtier (51) et
- des connexions électriques (53) qui dépassent du boîtier (51) et sont raccordées aux contacts (5, 5a, 5b).

12. Module capteur (50) selon la revendication 11, **caractérisé par** un élément de reproduction optique, notamment une lentille (52) ou un miroir.

13. Procédé pour la fabrication d'un capteur de rayonnement (10), comprenant les étapes consistant à :
fabriquer une plaquette plane,
déposer une couche d'arrêt de gravure sur une première surface de la plaquette et placer par-dessus une membrane mécaniquement stable,
déposer un masque de gravure muni d'une ouverture sur une deuxième surface de la plaquette, et
graver à sec des matrices dans la plaquette depuis la deuxième surface en direction de la couche d'arrêt de gravure afin que la paroi latérale de la matrice (2) soit perpendiculaire à la première surface de la plaquette,
**caractérisé en ce que**
un masque de gravure ayant une ouverture à contour rond ou ovale est déposé et une matrice se présente avec une section transversale ronde ou ovale en conséquence.
